# EUROPEAN PATENT SPECIFICATION

(11) **EP 4 017 028 B1**
(45) Date of publication and mention of the grant of the patent: **14.10.2026**
(21) Application number: 21214677.3
(22) Date of filing: 15.12.2021
(51) Int. Cl.: H04R 19/00, H04R 19/04, B81B 3/00, H04R 3/00

(54) **SIGNAL PROCESSING CIRCUIT FOR TRIPLE-MEMBRANE MEMS DEVICE**
SIGNALVERARBEITUNGSSCHALTUNG FÜR DREIFACH-MEMBRAN-MEMS-VORRICHTUNG
CIRCUIT DE TRAITEMENT DE SIGNAL POUR DISPOSITIF MEMS À TRIPLE MEMBRANE

(30) Priority: 21.12.2020 US 202017128638
(43) Date of publication of application: 22.06.2022
(73) Proprietor: Infineon Technologies AG, 85579 Neubiberg (DE)
(72) Inventor: FUELDNER, Marc, 85579 Neubiberg (DE); KOLLIAS, Athanasios, 81737 München (DE); WIESBAUER, Andreas, 9210 Poertschach (AT)
(74) Representative: Hersina, Günter

(56) References cited:
- US-A1- 2017 260 040
- US-A1- 2018 091 906
- US-A1- 2019 039 884

## Description

### TECHNICAL FIELD

The present invention relates generally to a signal processing circuit configured to read-out output signals of a triple-membrane MEMS device.

### BACKGROUND

A microphone is an acoustic sensor converting an acoustic pressure wave to an electric signal. The microphone includes a microelectromechanical system (MEMS) sensor and an application specific integrated circuit (ASIC). The MEMS sensor and the ASIC are disposed in a single package. The MEMS sensor and the ASIC are connected together through suitable electrical connections.

The MEMS sensor functions as a variable capacitor having a fixed plate and a movable plate. The movable plate is also known as a membrane. When an acoustic pressure wave is applied to the MEMS sensor, the membrane is able to move in response to the acoustic pressure wave. The movement of the membrane relative to the fixed plate varies the distance between the membrane and the fixed plate of the variable capacitor, which in turn varies the capacitance of the variable capacitor. The variation of the capacitance is determined by various parameters of the acoustic pressure wave such as sound pressure levels of the acoustic pressure wave. The variation of the capacitance of the MEMS sensor is converted into an analog signal, which is fed into the ASIC for further processing. US 2018/091906 A1, US 2017/260040, and US 2019/039884 A1, each refers to a MEMS device.

As semiconductor technologies further advance, a sealed dual-membrane MEMS silicon microphone has emerged to further improve key performance characteristics such as low noise and reliability. The sealed dual-membrane MEMS silicon microphone typically includes a top membrane, a bottom membrane, a perforated stator, a top isolation layer between the peripheral portions of the top membrane and the stator, a bottom isolation layer between the peripheral portions of the bottom membrane and the stator, and at least one pillar coupled between the top membrane and the bottom membrane.

The sealed dual-membrane MEMS silicon microphone is good for reducing noise. But there is still ASIC noise. More capacitance is helpful to further reduce the ASIC noise. There is a need to increase the capacitance of the MEMS silicon microphone so as to meet the requirements of the ever-changing MEMS microphone.

### SUMMARY

The scope of protection is defined by the appended claims.

The following detailed description of the disclosure may be used to be better the present teaching. Additional features and advantages of the disclosure will be described hereinafter which form the subject of the claims of the disclosure. It should be appreciated by those skilled in the art that the conception and specific embodiment disclosed may be readily utilized as a basis for modifying or designing other structures or processes for carrying out the same purposes of the present disclosure.

### BRIEF DESCRIPTION OF THE DRAWINGS

For a more complete understanding of the present disclosure, and the advantages thereof, reference is now made to the following descriptions taken in conjunction with the accompanying drawings, in which:
Figure 1 illustrates a cross sectional view of a triple-membrane MEMS microphone in accordance with various embodiments of the present disclosure;
Figure 2 illustrates a simplified view of the triple-membrane MEMS microphone shown in Figure 1 in accordance with various embodiments of the present disclosure;
Figure 3 illustrates an equivalent source model of a single MEMS element of the triple-membrane MEMS microphone in accordance with various embodiments of the present disclosure;
Figure 4 illustrates a schematic diagram of a first read-out operating mode of the triple-membrane MEMS microphone in accordance with various embodiments of the present disclosure;
Figure 5 illustrates another schematic diagram of the first read-out operating mode of the triple-membrane MEMS microphone in accordance with various embodiments of the present disclosure;
Figure 6 illustrates a schematic diagram of a second read-out operating mode of the triple-membrane MEMS microphone in accordance with various embodiments of the present disclosure;
Figure 7 illustrates another schematic diagram of the second read-out operating mode of the triple-membrane MEMS microphone in accordance with various embodiments of the present disclosure;
Figure 8 illustrates a schematic diagram of a third read-out operating mode of the triple-membrane MEMS microphone in accordance with various embodiments of the present disclosure;
Figure 9 illustrates a schematic diagram of a fourth read-out operating mode of the triple-membrane MEMS microphone in accordance with various embodiments of the present disclosure;
Figure 10 illustrates a schematic diagram of a fifth read-out operating mode of the triple-membrane MEMS microphone in accordance with various embodiments of the present disclosure;
Figure 11 illustrates a schematic diagram of a sixth read-out operating mode of the triple-membrane MEMS microphone in accordance with various embodiments of the present disclosure; and
Figure 12 illustrates a flow chart of a method of reading-out the triple-membrane MEMS microphone shown in Figure 2 in accordance with various embodiments of the present disclosure.

Corresponding numerals and symbols in the different figures generally refer to corresponding parts unless otherwise indicated. The figures are drawn to clearly illustrate the relevant aspects of the various embodiments and are not necessarily drawn to scale.

### DETAILED DESCRIPTION OF ILLUSTRATIVE EMBODIMENTS

The making and using of the presently preferred embodiments are discussed in detail below. It should be appreciated, however, that the present disclosure provides many applicable inventive concepts that can be embodied in a wide variety of specific contexts. The specific embodiments discussed are merely illustrative of specific ways to make and use the disclosure, and do not limit the scope of the disclosure.

The present disclosure will be described with respect to preferred embodiments in a specific context, namely a signal processing circuit configured to read-out output signals of a triple-membrane MEMS device. The signal processing circuit of the present disclosure may also be applied, however, to a variety of MEMS devices. Hereinafter, various embodiments will be explained in detail with reference to the accompanying drawings.

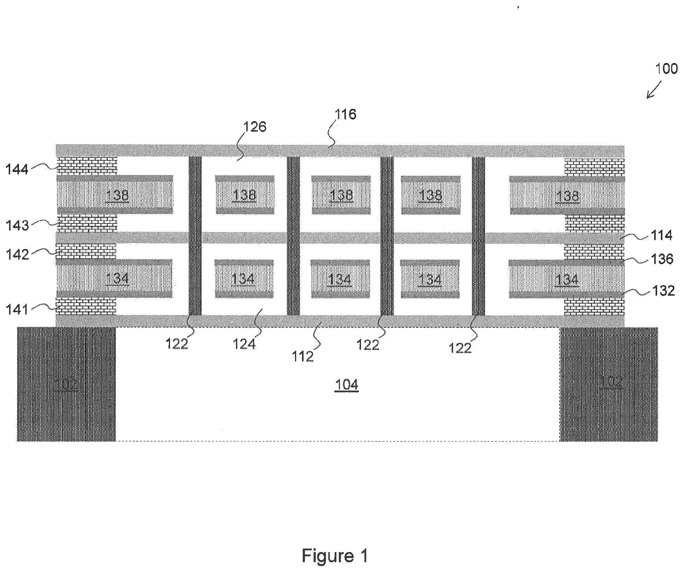

Figure 1 illustrates a cross sectional view of a triple-membrane MEMS microphone in accordance with various embodiments of the present disclosure. The triple-membrane MEMS microphone 100 comprises a first membrane 112, a second membrane 114 and a third membrane 116 spaced apart from one another. As shown in Figure 1, the second membrane 114 is between the first membrane 112 and the third membrane 116. In some embodiments, the first membrane 112, the second membrane 114 and the third membrane 116 may be formed of conductive materials. Furthermore, the first membrane 112, the second membrane 114 and the third membrane 116 are movable membranes.

The triple-membrane MEMS microphone 100 further comprise a first low pressure region 124, a second low pressure region 126, a plurality of pillars 122 and a plurality of first stators 134 and a plurality of second stators 138. As shown in Figure 1, the first low pressure region 124 is between the first membrane 112 and the second membrane 114. The second low pressure region 126 is between the second membrane 114 and third second membrane 116. The plurality of first stators 134 is in the first low pressure region 124. The plurality of second stators 138 is in the second low pressure region 126. It should be noted that the plurality of first stators 134 shown in Figure 1 may be from a single stator plane having a plurality of openings. As such, the plurality of first stators 134 may be alternatively referred to as a first stator 134. Likewise, the plurality of second stators 138 shown in Figure 1 may be from another single stator plane having a plurality of openings. As such, the plurality of second stators 138 may be alternatively referred to as a second stator 138.

The triple-membrane MEMS microphone 100 is formed over a support substrate 102. As shown in Figure 1, the peripheral portions of the first membrane 112 are on the support substrate 102. A backside cavity 104 may be formed in the support substrate 102. The backside cavity 104 is employed to allow the first membrane 112 to oscillate in response to a sound wave. According to various embodiments, the backside cavity 104 may formed in the support substrate 102 through various etching techniques such as isotropic gas phase etching, vapor etching, wet etching, isotropic dry etching, plasma etching, any combinations thereof and the like.

In some embodiments, the support substrate 102 may be a silicon substrate. Alternatively, the support substrate 102 may be formed of any suitable semiconductor materials. For example, the support substrate 102 may be formed of semiconductor materials such as germanium, silicon germanium, silicon carbide, gallium nitride, indium, indium gallium nitride, indium gallium arsenide, indium gallium zinc oxide, any combinations thereof and the like. Furthermore, the support substrate 102 may be formed of suitable compound semiconductor materials such as III-V compound semiconductor materials and/or II-VI compound semiconductor materials.

As shown in Figure 1, the first membrane 112 and the third membrane 116 form a chamber. In some embodiments, the chamber is a sealed chamber. The chamber includes the first low pressure region 124 and the second low pressure region 126. The pressure inside the chamber is lower than the pressure outside the chamber. In other words, the first low pressure region and the second low pressure region have a pressure less than an outer pressure. In some embodiments, the outer pressure is a pressure outside the membranes (outside the chamber). The outer pressure is equal to an atmospheric pressure or an ambient pressure.

In some embodiments, the pressure inside the chamber may be a vacuum. In some embodiments, the pressure in the first low pressure region 124 may be different from that of the second low pressure region 126. In alternative embodiments, the second membrane 114 may have a plurality of openings. As a result of having the plurality of openings in the second membrane 114, the pressure in the first low pressure region 124 is equal to the pressure of the second low pressure region 126.

As shown in Figure 1, each stator (e.g., first stator 134) may comprise a first counter electrode element 132 and a second counter electrode element 136. The second counter electrode element 136 may be spaced apart from the first counter electrode element 132. More particularly, a counter electrode isolating layer is formed between the first counter electrode element 132 and the second counter electrode element 136. In some embodiments, the counter electrode isolating layer may be formed of suitable dielectric materials such as a silicon oxide, a silicon nitride and the like.

In some embodiments, the first counter electrode element 132 and the second counter electrode element 136 may be formed of various metals such as copper, aluminum, silver, nickel, and various suitable alloys. Alternatively, the first counter electrode element 132 and the second counter electrode element 136 may be formed of various semiconductor materials which may be doped such that they are electrically conductive (e.g., a polysilicon layer heavily doped with boron, phosphorus, or arsenic).

As shown in Figure 1, the first stator 134 is at least partially arranged in the first low pressure region 124 or extends in the first low pressure region 124. Likewise, the second stator 138 is at least partially arranged in the second low pressure region 126 or extends in the second low pressure region 126.

Figure 1 shows some portions of the stators may be supported at its periphery or circumference by a support structure (e.g., membrane isolation layers 141-144). Figure 1 also shows some portions of the stators appear to be "floating" within the low pressure regions 124 and 126. It should be noted that the "floating" portions of the stators may be typically attached to the circumference of the stators.

The plurality of pillars 122 extends between the first membrane 112 and the third membrane 116. More particularly, a first terminal of each pillar extends through the first membrane 112. A second terminal of each pillar extends through the third membrane 116. In some embodiments, one or more pillars are electrically conductive. The conductive pillar provides a mechanical and electrical coupling between at least two membranes. In alternative embodiments, the pillars are electrically insulating. The non-conductive pillars provide a mechanical coupling between at least two membranes.

The plurality of pillars 122 is mechanically coupled to the first membrane 112, the second membrane 114 and the third membrane 116. As shown in Figure 1, the pillars 122 typically do not contact or touch the first stator 134 and the second stator 138. The pillars 122 may pass through the stators 134 and 138 through openings or holes in the stators 134 and 138.

In the process of fabricating the triple-membrane MEMS microphone 100, the pillars 122 may be integrally formed with the first membrane 112, the second membrane 114 and the third membrane 116. Hence, the first membrane 112, the second membrane 114, the third membrane 116, and the pillars 122 may form an integral structure of the same material such as polycrystalline silicon and the like. Alternatively, the membranes 112, 114, 116 and the pillars 122 may be formed of different materials. For example, the first membrane 112 may be formed first on a surface of the support substrate 102 during a first deposition process. Subsequently, the pillars 122 and eventually also the other membranes 114 and 116 may be formed during subsequent deposition processes. In some embodiments, the pillars 122, which ensure a mechanical coupling among the membranes, do not provide an electrical connection between the two membranes. The pillars 122 can be made of an insulating material, like silicon, nitride, silicon oxide, a polymer or a combination of the former materials, or a combination of the former material.

The support structure of the triple-membrane MEMS microphone 100 may have a stacked configuration. The support structure of the triple-membrane MEMS microphone 100 includes the support substrate 102, a first membrane isolation layer 141, a second membrane isolation layer 142, a third membrane isolation layer 143 and a fourth membrane isolation layer 144. In some embodiments, the peripheral portions of the membranes 112, 114 and 116, and the stators 134, 138 may be in contact with the support structure as shown in Figure 1. In particular, Figure 1 shows the various membrane isolation layers of the support structure and the membranes may be arranged on top of each other in the following order, for example: the first membrane 112, the first membrane isolation layer 141, the first counter electrode element of the first stator 134, the counter electrode isolating layer of the first stator 134, the second counter electrode element of the first stator 134, the second membrane isolation layer 142, the second membrane 114, the third membrane isolation layer 143, the first counter electrode element of the second stator 138, the counter electrode isolating layer of the second stator 138, the second counter electrode element of the second stator 138, the fourth membrane isolation layer 144 and the third membrane 116.

It should be noted that while Figure 1 shows the membrane isolation layer (e.g., the first membrane isolation layer 141) is of a vertical sidewall, for achieving high robustness, the membrane isolation layer may be a tapered sidewall. For example, the first membrane isolation layer 141 may be of a tapered sidewall oriented in a first direction. The second membrane isolation layer 142 may be of a tapered sidewall oriented in a second direction. The first direction and the second direction are opposite to each other.

After having the support structure shown in Figure 1, each membrane (e.g., first membrane 112) comprises a movable portion and a fixed portion. The fixed portion of the first membrane 112 is, for example, mechanically connected to the support substrate 102 and the first membrane isolation layer 141.

Figure 1 shows the triple-membrane MEMS microphone 100 at its rest position, e.g. when no sound wave arrives at the membranes. The sound wave could cause the membranes 112, 114 and 116 to be deflected. As shown in Figure 1, the third membrane 116 may be exposed to an ambient pressure and potentially a sound pressure. This top side of the third membrane 116 may also be regarded as a sound receiving main surface of the triple-membrane MEMS microphone 100.

In some embodiments, when sound waves are incident on the membranes (e.g., the top side of the third membrane 116), the membranes may deflect and/or oscillate. A displacement of one membrane (e.g., the third membrane 116) may result in the corresponding displacements of the second membrane 114 and the first membrane 112 if they are mechanically coupled to each other. The third membrane 116 may deflect in a direction substantially toward the second stator 138 while the second membrane 114 may simultaneously be deflected in substantially the same direction as the third membrane 116 and therefore may move away from the second stator 138. Likewise, the second membrane 114 may deflect in a direction substantially toward the first stator 134 while the first membrane 112 may simultaneously be deflected in substantially the same direction as the second membrane 114 and therefore may move away from the first stator 134.

In some embodiments, the top side of the third membrane 116 at which the sound may arrive, the total pressure may be equal to the sum of the normal pressure (e.g., the atmospheric pressure) and the sound pressure. Within the backside cavity 104, only the normal atmospheric pressure may be present.

In some embodiments, the first membrane 112 and the first stator 134 form a first capacitor. The first stator 134 and the second membrane 114 form a second capacitor. The second membrane 114 and the second stator 138 form a third capacitor. The second stator 138 and the third membrane 116 form a fourth capacitor.

In operation, the capacitance variations of the four capacitors are observed. A first capacitance variation is based on the first capacitor, which is formed between the first membrane 112 and the first stator 134. A second capacitance variation is based on the second capacitor, which is formed between the first stator 134 and the second membrane 116. A third capacitance variation is based on the third capacitor, which is formed between the second membrane 114 and the second stator 138. A fourth capacitance variation is based on the fourth capacitor, which is formed between the second stator 138 and the third membrane 116. The capacitances of these four capacitors vary in relation to the movement of the movable portions of the first, second and third membranes 112, 114 and 116 with respect to the stators 134 and 138. The movement of the movable portions of the membranes 112, 114 and 116 is generated by, for example, sound pressure changes caused by speech, music and the like.

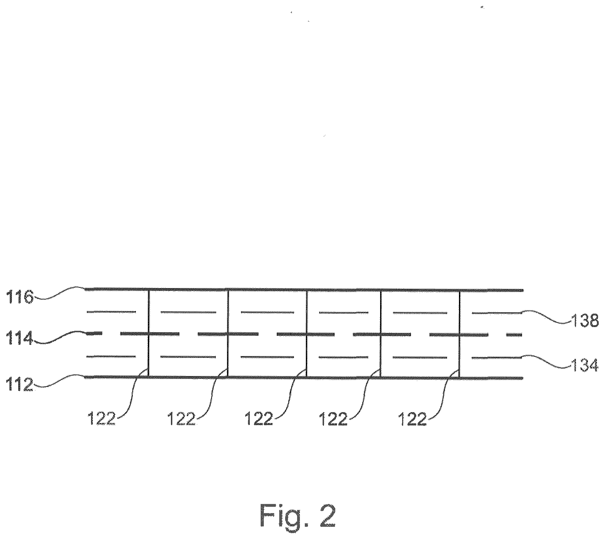

Figure 2 illustrates a simplified view of the triple-membrane MEMS microphone shown in Figure 1 in accordance with various embodiments of the present disclosure. The triple-membrane MEMS microphone comprises a first membrane 112, a second membrane 114 and a third membrane 114 spaced apart from one another. As shown in Figure 2, the second membrane 114 is between the first membrane 112 and the third membrane 114. In some embodiments, a sealed low pressure chamber is formed between the first membrane 112 and the third membrane 116. A first stator 134 and a second stator 138 are in the sealed low pressure chamber.

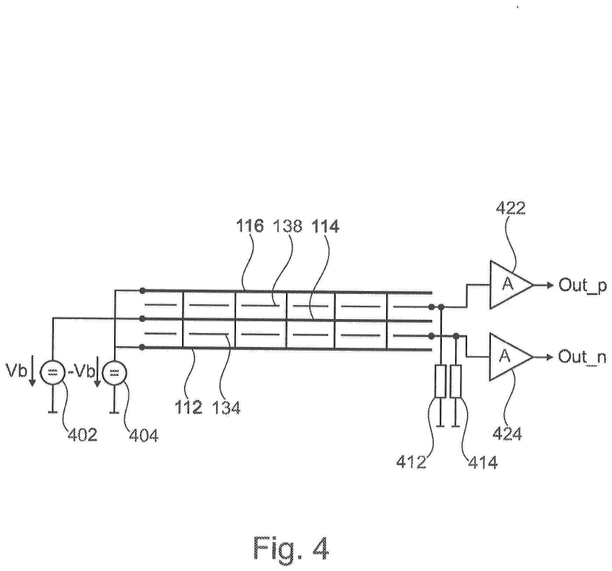

In some embodiments, a first capacitor is formed between the first membrane 112 and the first stator 134. A second capacitor is formed between the first stator 134 and the second membrane 114. A third capacitor is formed between the second membrane 114 and the second stator 138. A fourth capacitor is formed between the second stator 138 and the third membrane 116. When a plurality of bias voltages is applied to the capacitors, and sound waves cause the membranes 112, 114 and 116 to move, the sound waves can be converted into useable electrical signals by measuring the capacitance changes caused by the movement of the membranes relative to the stators. A signal processing circuit is coupled to the triple-membrane MEMS microphone. The signal processing circuit is configured to read-out the useable electrical signals generated by the triple-membrane MEMS microphone. The signal processing circuit will be discussed in detail below with respect to Figure 4-11.

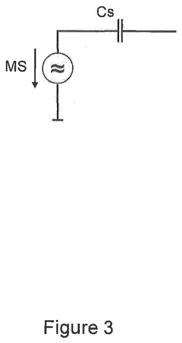

Figure 3 illustrates an equivalent source model of a single MEMS element of the triple-membrane MEMS microphone in accordance with various embodiments of the present disclosure. The circuit shown in Figure 3 represents an AC equivalent circuit of a single MEMS element such as one capacitor of the four capacitors described above with respect to Figure 2. In the equivalent circuit, MS is the motor sensitivity of the MEMS element. Cs is the source capacitance of the MEMS element.

The four capacitors described above may be arranged in a series configuration to reach the highest sensitivity and the lowest output capacitance. In such an arrangement, the motor sensitivity of the triple-membrane MEMS microphone is equal to four times the motor sensitivity of the single MEMS element. The output capacitance of the triple-membrane MEMS microphone is equal to one fourth of the output capacitance of the single MEMS element. On the other hand, the four capacitors described above may be arranged in a parallel configuration to reach the lowest sensitivity and the highest output capacitance. In such an arrangement, the motor sensitivity of the triple-membrane MEMS microphone is equal to the motor sensitivity of the single MEMS element. The output capacitance of the triple-membrane MEMS microphone is equal to four times the output capacitance of the single MEMS element. In other words, the first capacitor, the second capacitor, the third capacitor and the fourth capacitor are configured in a series configuration to increase motor sensitivity of the MEMS device or in a parallel configuration to reduce an output impedance of the MEMS device. The detailed configurations of these four capacitors will be described below with respect to Figures 4-11.

Figure 4 illustrates a schematic diagram of a first read-out operating mode of the triple-membrane MEMS microphone in accordance with various embodiments of the present disclosure. As shown in Figure 4, the signal processing circuit of the first read-out operating mode comprises a first bias voltage source 402, a second bias voltage source 404, a first resistor 412, a second resistor 414, a first amplifier 422 and a second amplifier 424. The first bias voltage source 402 is a positive voltage source configured to produce a positive bias voltage. In some embodiments, the output voltage (Vb) of the first bias voltage source 402 is in a range from about 5 V to about 15 V. The second bias voltage source 404 is a negative voltage source configured to produce a negative bias voltage. In some embodiments, the output voltage (-Vb) of the second bias voltage source 404 is in a range from about -5 V to about -15 V.

It should be noted the voltage sources shown in Figure 4 are merely an example. Depending on different applications and design needs, the voltage sources throughout the description may be implemented as a filtered voltage source. In other words, a filter such as a resistor-capacitor (RC) filter may be connected to the output of the voltage source. Furthermore, a voltage source may be indirectly coupled to a circuit to be powered by the voltage source. For example, a large resistor may be coupled between the output of a voltage source and a filter. The large resistor provides a high ohmic connection between the voltage source and the circuit to be powered by the voltage source.

As shown in Figure 4, the second bias voltage source 404 is configured to bias the first membrane 112 and the third membrane 116. The first bias voltage source 402 is configured to bias the second membrane 114.

The first amplifier 422 is connected to the second stator 138. The first amplifier 422 is configured to read-out a positive output signal (Out_p) of the triple-membrane MEMS microphone. The first resistor 412 is coupled between the input of the first amplifier 422 and a first predetermined voltage potential. In some embodiments, the first resistor 412 is a 100 Giga-ohm resistor. The first predetermined voltage potential is equal to zero. Alternatively, depending on different applications and design needs, the first predetermined voltage potential may be any suitable voltage levels such as a voltage level in a range from about 0.1 V to about 1 V.

The second amplifier 424 is connected to the first stator 134. The second amplifier 424 is configured to read-out a negative output signal (Out_n) of the triple-membrane MEMS microphone. The second resistor 414 is coupled between the input of the second amplifier 424 and a second predetermined voltage potential. In some embodiments, the second resistor 414 is a 100 Giga-ohm resistor. The second predetermined voltage potential is equal to zero. Alternatively, depending on different applications and design needs, the second predetermined voltage potential may be any suitable voltage levels such as a voltage level in a range from about 0.1 V to about 1 V.

In the triple-membrane MEMS microphone, a first capacitor is formed between the first membrane 112 and the first stator 134. A second capacitor is formed between the first stator 134 and the second membrane 114. A third capacitor is formed between the second membrane 114 and the second stator 138. A fourth capacitor is formed between the second stator 138 and the third membrane 116.

In the first read-out operating mode, the first capacitor and the second capacitor are configured to be connected in parallel through the first bias voltage source 402 and the second bias voltage source 404. The third capacitor and the fourth capacitor are configured to be connected in parallel through the first bias voltage source 402 and the second bias voltage source 404.

The arrangement of the four capacitor of Figure 4 forms a parallel differential read-out configuration. The motor sensitivity provided to the first amplifier 422 and the second amplifier 424 is equal to the motor sensitivity of a single MEMS element (e.g., MS shown in Figure 3). The output capacitance coupled to the first amplifier 422 and the second amplifier 424 is equal to two times the output capacitance of the single MEMS element.

One advantageous feature of the first read-out operating mode is the parallel differential read-out configuration provides moderate sensitivity and good leakage robustness.

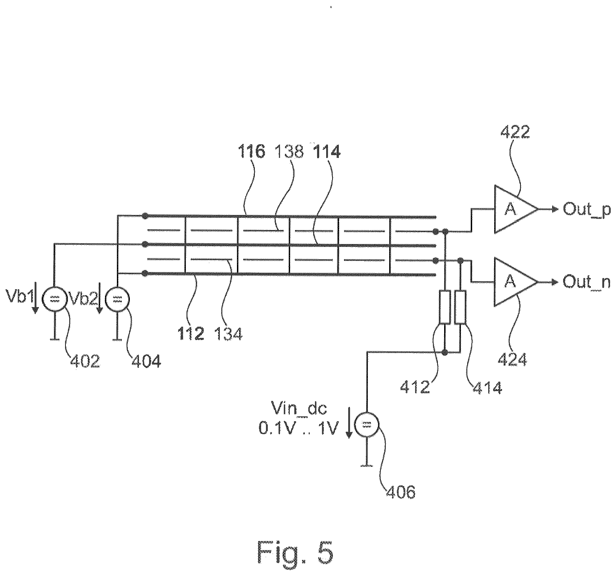

Figure 5 illustrates another schematic diagram of the first read-out operating mode of the triple-membrane MEMS microphone in accordance with various embodiments of the present disclosure. The parallel differential read-out configuration shown in Figure 5 is similar to that shown in Figure 4 except that the first resistor 412 and the second resistor 414 are connected to a same voltage source Vin_dc. In some embodiments, the voltage of is in a range from about 0.1 V to about 1 V. Furthermore, the first bias voltage source 402 and the second bias voltage source 404 are configured such that the bias circuit shown in Figure 5 provides symmetric biasing. In particular, the output voltage of the first bias voltage source 402 can be expressed by the following equation: $Vb 1 = Vb + Vin _ dc$ (1)

The output voltage of the second bias voltage source 404 can be expressed by the following equation: $Vb 2 = - \left(Vb-Vin_dc\right)$ (2)

According to Equations (1) and (2) above, the voltage of the membranes and the voltage of the stators satisfy the following equation: $\left|Vmembrane-Vstator\right| = Vb$ (3)

In Equation (3), Vmembrance is the voltage of the membranes (e.g., first membrane 112). Vstator is the voltage of the stators *(e.g.,* first stator 134).

It should be noted while Figure 5 illustrates a symmetric biasing circuit, the various embodiments of the present disclosure may include an asymmetric biasing circuit. In particular, the asymmetric biasing circuit may be used to compensate the asymmetries of the triple-membrane MEMS microphone.

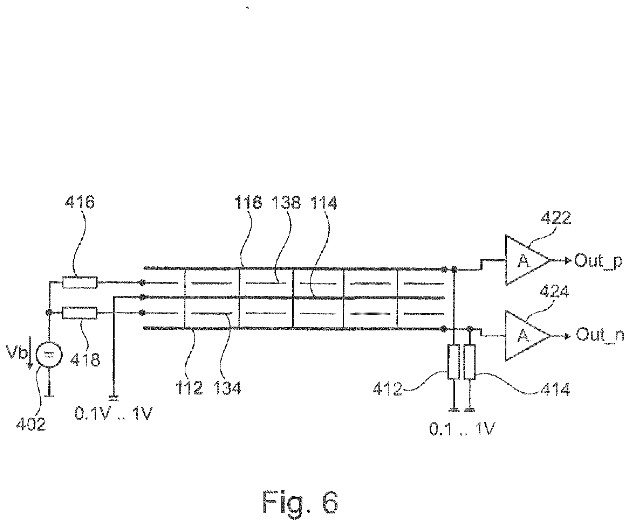

Figure 6 illustrates a schematic diagram of a second read-out operating mode of the triple-membrane MEMS microphone in accordance with various embodiments of the present disclosure. As shown in Figure 6, the signal processing circuit of the second read-out operating mode comprises a first bias voltage source 402, a first resistor 412, a second resistor 414, a third resistor 416, a fourth resistor 418, a first amplifier 422 and a second amplifier 424. The first bias voltage source 402 is a positive voltage source. In some embodiments, the output voltage of the first bias voltage source 402 is configured to produce a positive bias voltage in a range from about 5 V to about 15 V.

As shown in Figure 6, the first bias voltage source 402 is configured to bias the first stator 134 and the second stator 138. More particularly, the first bias voltage source 402 is connected to the first stator 134 and the second stator 138 through the fourth resistor 418 and the third resistor 416, respectively. A predetermined voltage potential is configured to be coupled to the second membrane 114. The predetermined voltage potential is in a range from about 0.1 V to about 1 V.

The first amplifier 422 is connected to the third membrane 116. The first amplifier 422 is configured to read-out a positive output signal of the triple-membrane MEMS microphone. The second amplifier 424 is connected to the first membrane 112. The second amplifier 424 is configured to read-out a negative output signal of the triple-membrane MEMS microphone.

The first resistor 412 is coupled between the input of the first amplifier 422 and a first predetermined voltage potential. In some embodiments, the first resistor 412 is a 100 Giga-ohm resistor. In some embodiments, the first predetermined voltage potential may be any suitable voltage levels such as a voltage level in a range from about 0.1 V to about 1 V.

The second resistor 414 is coupled between the input of the second amplifier 424 and a second predetermined voltage potential. In some embodiments, the second resistor 414 is a 100 Giga-ohm resistor. The second predetermined voltage potential may be any suitable voltage levels such as a voltage level in a range from about 0.1 V to about 1 V.

The resistors 416 and 418 need to be sized such that the impedance is higher than the impedance of the MEMS capacitors at the lower frequency limit of the desired audio frequency band (e.g., 20 Hz). According to this selection principle, the value of the resistors 416 and 418 is greater than 10 Giga-ohm.

In the second read-out operating mode, the first capacitor and the second capacitor are configured to be connected in series. The third capacitor and the fourth capacitor are configured to be connected in series. The arrangement of the four capacitor forms a serial differential read-out configuration. The motor sensitivity provided to the first amplifier 422 and the second amplifier 424 is equal to two times the motor sensitivity of a single MEMS element. The output capacitance coupled to the first amplifier 422 and the second amplifier 424 is equal to one half of the output capacitance of a single MEMS element.

One advantageous feature of the second read-out operating mode is the series differential read-out configuration provides high sensitivity and moderate leakage robustness. The high sensitivity helps to lower the cost of the ASIC in which the signals generated by the triple-membrane MEMS microphone are processed.

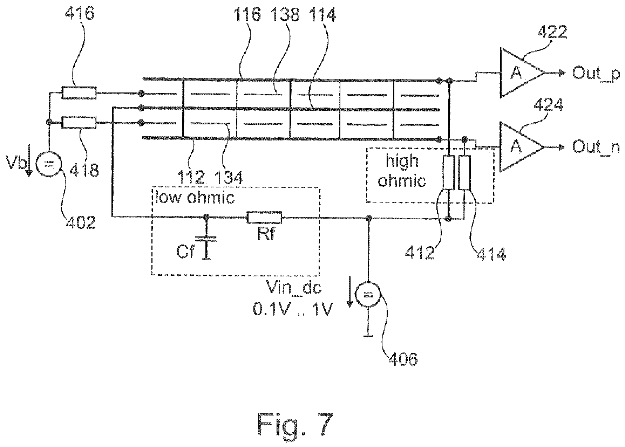

Figure 7 illustrates another schematic diagram of the second read-out operating mode of the triple-membrane MEMS microphone in accordance with various embodiments of the present disclosure. The serial differential read-out configuration shown in Figure 7 is similar to that shown in Figure 6 except that the biasing of the second membrane 114 is derived from the input biasing of the ASIC in which the signals generated by the triple-membrane MEMS microphone are processed. A voltage source 406 is derived from the input biasing of the ASIC. Through a filter formed by Rf and Cf, the voltage Vin_dc of the voltage source 406 is applied to the second membrane 114. The effective bias voltage of the triple-membrane MEMS microphone is equal to the difference of Vb and Vin_dc.

In some embodiments, the filter capacitor Cf has a significantly larger value than the capacitance values *(e.g.,* the capacitance values of the four capacitors) of the triple-membrane MEMS microphone.

In some embodiments, Rf is of a low resistance value so as to provide a low ohmic coupling between the voltage source 406 and the second membrane 114. On the other hand, the first resistor 412 and the second resistor 414 are of a high resistance value so as to provide a high ohmic coupling between the voltage source 406 and the inputs of the amplifiers 422 and 424.

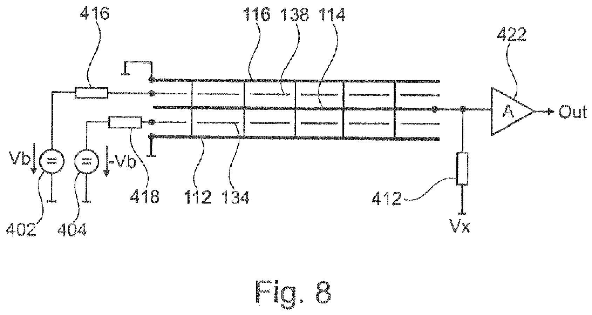

Figure 8 illustrates a schematic diagram of a third read-out operating mode of the triple-membrane MEMS microphone in accordance with various embodiments of the present disclosure. As shown in Figure 8, the signal processing circuit of the third read-out operating mode comprises a first bias voltage source 402, a second bias voltage source 404, a first resistor 412, a third resistor 416, a fourth resistor 418 and a first amplifier 422. The first bias voltage source 402 is a positive voltage source. In some embodiments, the output voltage of the first bias voltage source 402 is in a range from about 5 V to about 15 V. The second bias voltage source 404 is a negative voltage source. In some embodiments, the output voltage of the second bias voltage source 404 is in a range from about -5 V to about -15 V.

As shown in Figure 8, the second bias voltage source 404 is configured to bias the first stator 134. More particularly, the second bias voltage source 404 is connected to the first stator 134 through the fourth resistor 418. The first bias voltage source 402 is configured to bias the second stator 138. More particularly, the first bias voltage source 402 is connected to the second stator 138 through the third resistor 416.

A predetermined voltage potential is configured to be coupled to the first membrane 112 and the third membrane 116. In some embodiments, the predetermined voltage potential is about zero. The first amplifier 422 is connected to the second membrane 114. The first amplifier 422 is configured to read-out an output signal of the triple-membrane MEMS microphone. The output signal OUT is a positive output signal.

The first resistor 412 is coupled between the input of the first amplifier 422 and a first predetermined voltage potential (Vx). In some embodiments, the first resistor 412 is a 100 Giga-ohm resistor. The first predetermined voltage potential is equal to zero. Alternatively, depending on different applications and design needs, the first predetermined voltage potential may be any suitable voltage levels such as a voltage level in a range from about 0.1 V to about 1 V.

For achieving perfectly symmetric biasing conditions, the first membrane 112 and the third membrane 116 may be coupled to Vx. The output voltage level of the first bias voltage source 402 is configured to be equal to the sum of Vb and Vx. The output voltage level of the second bias voltage source 404 is configured to be equal to the sum of -Vb and Vx. The first membrane 112 and the third membrane 116 are coupled to Vx through an RC network (e.g., the RC network formed by Rf and Cf shown in Figure 7).

In the third read-out operating mode, the first capacitor and the second capacitor are configured to be connected in series. The third capacitor and the fourth capacitor are configured to be connected in series. Furthermore, the series-connected first capacitor and the second capacitor are configured to be connected in parallel with the series-connected third capacitor and the fourth capacitor.

The arrangement of the four capacitor forms a serial/parallel single ended read-out configuration. The motor sensitivity provided to the first amplifier 422 is equal to two times the motor sensitivity of a single MEMS element. The output capacitance coupled to the first amplifier 422 is equal to the output capacitance of a single MEMS element.

One advantageous feature of the third read-out operating mode is the serial/parallel single ended read-out configuration provides high sensitivity and good leakage robustness. Furthermore, the serial/parallel single ended read-out configuration simplifies the circuit connection, thereby reducing the cost of the triple-membrane MEMS microphone.

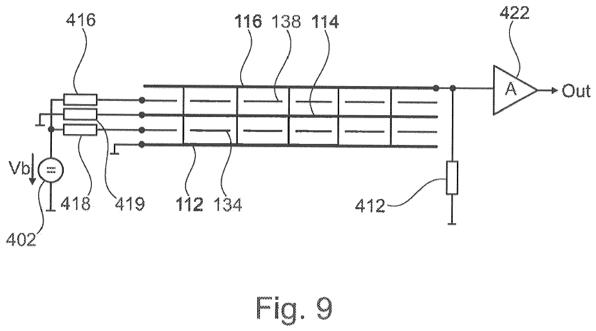

Figure 9 illustrates a schematic diagram of a fourth read-out operating mode of the triple-membrane MEMS microphone in accordance with various embodiments of the present disclosure. As shown in Figure 9, the signal processing circuit of the fourth read-out operating mode comprises a first bias voltage source 402, a first resistor 412, a third resistor 416, a fourth resistor 418, a fifth resistor 419 and a first amplifier 422. The first bias voltage source 402 is a positive voltage source. In some embodiments, the output voltage of the first bias voltage source 402 is in a range from about 5 V to about 15 V.

The first bias voltage source 402 is configured to bias the first stator 134 and the second stator 138 through the fourth resistor 418 and the third resistor 416, respectively. A predetermined voltage potential is configured to be coupled to the first membrane 112 and the second membrane 114. More particularly, the predetermined voltage potential is connected to the first membrane 112 directly and the second membrane 114 through the fifth resistor 419.

The first amplifier 422 is connected to the third membrane 116. The first amplifier 422 is configured to read-out an output signal of the triple-membrane MEMS microphone. The output signal OUT is a positive output signal. The connection of the first resistor 412 is similar to that shown in Figure 8, and hence is not discussed again herein.

In the fourth read-out operating mode, the first capacitor, the second capacitor, the third capacitor and the fourth capacitor are configured to be connected in series. The arrangement of the four capacitor forms a serial single ended read-out configuration. The motor sensitivity provided to the first amplifier 422 is equal to four times the motor sensitivity of a single MEMS element. The output capacitance coupled to the first amplifier 422 is equal to one fourth of the output capacitance of a single MEMS element.

One advantageous feature of the fourth read-out operating mode is the serial single ended read-out configuration provides high sensitivity. Furthermore, the serial single ended read-out configuration simplifies the circuit connection, thereby reducing the cost of the triple-membrane MEMS microphone.

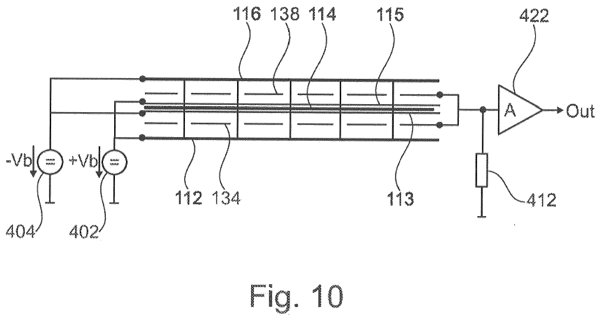

Figure 10 illustrates a schematic diagram of a fifth read-out operating mode of the triple-membrane MEMS microphone in accordance with various embodiments of the present disclosure. As shown in Figure 10, the signal processing circuit of the fifth read-out operating mode comprises a first bias voltage source 402, a second bias voltage source 404, a first resistor 412 and a first amplifier 422. The first bias voltage source 402 is a positive voltage source. In some embodiments, the output voltage of the first bias voltage source 402 is in a range from about 5 V to about 15 V. The second bias voltage source 404 is a negative voltage source. In some embodiments, the output voltage of the second bias voltage source 404 is in a range from about -5 V to about -15 V.

In the fifth read-out operating mode, the first bias voltage source 402 is configured to bias the first membrane 112 and a top electrode layer 115 of the second membrane with 114. The second bias voltage source 404 is configured to bias the third membrane 116 and a bottom electrode layer 113 of the second membrane 114.

The first amplifier 422 is connected to the first stator 134 and the second stator 138. The first amplifier 422 is configured to read-out an output signal of the triple-membrane MEMS microphone. The output signal OUT is a positive output signal. The connection of the first resistor 412 is similar to that shown in Figure 8, and hence is not discussed again herein.

In the fifth read-out operating mode, the first capacitor, the second capacitor, the third capacitor and the fourth capacitor are configured to be connected in parallel. The arrangement of the four capacitor forms a parallel single ended read-out configuration. The motor sensitivity provided to the first amplifier 422 is equal to the motor sensitivity of a single MEMS element. The output capacitance coupled to the first amplifier 422 is equal to four times the output capacitance of a single MEMS element.

One advantageous feature of the fifth read-out operating mode is the parallel single ended read-out configuration provides good leakage robustness. Furthermore, the parallel single ended read-out configuration simplifies the circuit connection, thereby reducing the cost of the triple-membrane MEMS microphone.

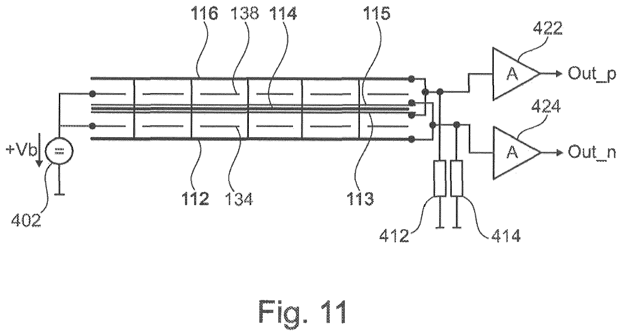

Figure 11 illustrates a schematic diagram of a sixth read-out operating mode of the triple-membrane MEMS microphone in accordance with various embodiments of the present disclosure. As shown in Figure 11, the signal processing circuit of the sixth read-out operating mode comprises a first bias voltage source 402, a first resistor 412, a second resistor 414, a first amplifier 422 and a second amplifier 424. The first bias voltage source 402 is a positive voltage source. In some embodiments, the output voltage of the first bias voltage source 402 is in a range from about 5 V to about 15 V. The first bias voltage source 402 is configured to bias the first stator 134 and the second stator 138.

In the sixth read-out operating mode, the third membrane 116 and a bottom electrode layer 113 of the second membrane 114 are connected together and further connected to an input of the first amplifier 422. The first amplifier 422 is configured to read-out a positive output signal of the triple-membrane MEMS microphone. The first membrane 112 and a top electrode layer 115 of the second membrane 114 are connected together and further connected to an input of the second amplifier 424. The second amplifier 424 is configured to read-out a negative output signal of the triple-membrane MEMS microphone. The connection of the first resistor 412 and the second resistor 414 is similar to that shown in Figure 4, and hence is not discussed again herein.

In the sixth read-out operating mode, the first capacitor and the third capacitor are configured to be connected in parallel and from a first read-out electrode. The second capacitor and the fourth capacitor are configured to be connected in parallel and form a second read-out electrode.

The arrangement of the four capacitor forms a parallel differential read-out configuration. The motor sensitivity provided to the first amplifier 422 and the second amplifier 424 is equal to the motor sensitivity of a single MEMS element. The output capacitance coupled to the first amplifier 422 and the second amplifier 424 is equal to four times the output capacitance of a single MEMS element.

One advantageous feature of the sixth read-out operating mode is the parallel differential read-out configuration helps to reduce the number of bond wires used for the triple-membrane MEMS microphone, thereby reducing the cost of the triple-membrane MEMS microphone.

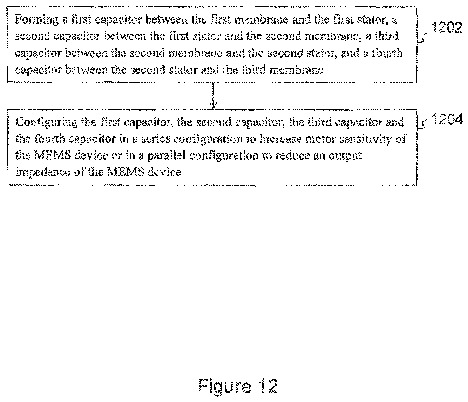

Figure 12 illustrates a flow chart of a method of reading-out the triple-membrane MEMS microphone shown in Figure 2 in accordance with various embodiments of the present disclosure. This flowchart shown in Figure 12 is merely an example, which should not unduly limit the scope of the claims. One of ordinary skill in the art would recognize many variations, alternatives, and modifications. For example, various steps illustrated in Figure 12 may be added, removed, replaced, rearranged and repeated.

An MEMS device comprises a first membrane, a second membrane and a third membrane spaced apart from one another. The second membrane is between the first membrane and the third membrane. The MEMS device further comprises a first stator between the first membrane and a second membrane, and a second stator between a second membrane and a third membrane.

At step 1202, a first capacitor is formed between the first membrane and the first stator. A second capacitor is formed between the first stator and the second membrane. A third capacitor is formed between the second membrane and the second stator. A fourth capacitor is formed between the second stator and the third membrane.

At step 1204, the first capacitor, the second capacitor, the third capacitor and the fourth capacitor are configured to be connected in a series to increase motor sensitivity of the MEMS device. Alternatively, the first capacitor, the second capacitor, the third capacitor and the fourth capacitor are configured to be connected in a parallel to reduce an output impedance of the MEMS device.

Although embodiments of the present disclosure and its advantages have been described in detail, it should be understood that various changes, substitutions and alterations can be made, provided that they fall within the scope of the appended claims.

Moreover, the scope of the present application is not intended to be limited to the particular embodiments of the process, machine, manufacture, composition of matter, means, methods and steps described in the specification. As one of ordinary skill in the art will readily appreciate from the disclosure of the present disclosure, processes, machines, manufacture, compositions of matter, means, methods, or steps, presently existing or later to be developed, that perform substantially the same function or achieve substantially the same result as the corresponding embodiments described herein may be utilized according to the present disclosure.

## Claims

1. A method of reading-out a microelectromechanical system (MEMS) device (100), the MEMS device (100) comprising a first membrane (112), a second membrane (114) and a third membrane (116) spaced apart from one another, the second membrane (114) being between the first membrane (112) and the third membrane (116), a first stator (134) between the first membrane (112) and the second membrane (114), and a second stator (138) between the second membrane (114) and the third membrane (116), a sealed low pressure chamber between the first membrane (112) and the third membrane (116);
the first stator (134) and the second stator (138) being in the sealed low pressure chamber; and
a signal processing circuit configured to read-out output signals of the triple-membrane MEMS device (100), wherein the signal processing circuit comprises a first bias voltage source (402), a first resistor (412), and a first amplifier (422) , the method comprising:
forming a first capacitor between the first membrane (112) and the first stator (134), a second capacitor between the first stator (134) and the second membrane (114), a third capacitor between the second membrane (114) and the second stator (138), and a fourth capacitor between the second stator (138) and the third membrane (116); and
configuring the first capacitor, the second capacitor, the third capacitor and the fourth capacitor in a series configuration to increase motor sensitivity of the MEMS device (100) or in a parallel configuration to reduce an output impedance of the MEMS device (100), when reading out the output signals in one of a first, a second, a third, a fourth, a fifth or a sixth read-out operations mode, wherein
a) in the first read-out operating mode, the first capacitor and the second capacitor are configured to be connected in parallel through the first bias voltage source (402) and a second bias voltage source (404), the third capacitor and the fourth capacitor are configured to be connected in parallel through the first bias voltage source (402) and the second bias voltage source (404), wherein, in the first read-out operating mode corresponding to one of the parallel configurations, the method comprises:
biasing the first membrane (112) and the third membrane (116) with the first bias voltage source (404);
biasing the second membrane (114) with the second bias voltage source (402);
reading-out a positive output signal through the first amplifier (422) connected to the second stator (138); and
reading-out a negative output signal through the second amplifier (424) connected to the first stator (134);
b) in the second read-out operating mode, the first capacitor and the second capacitor are configured to be connected in series, the third capacitor and the fourth capacitor are configured to be connected in series; the arrangement of the four capacitor forms a serial differential read-out configuration, wherein the motor sensitivity provided to the first amplifier (422) and the second amplifier (424) is equal to two times the motor sensitivity of a single MEMS element wherein the output capacitance coupled to the first amplifier (422) and the second amplifier (424) is equal to one half of the output capacitance of a single MEMS element, wherein, in the second read-out operating mode, the method comprises:
biasing the first stator (134) and the second stator (138) with the second bias voltage source (402);
coupling the second membrane (114) to a predetermined voltage potential;
reading-out a positive output signal through the first amplifier (422) connected to the third membrane (116); and
reading-out a negative output signal through the second amplifier (424) connected to the first membrane (112);
c) in the third read-out operating mode, the first capacitor and the second capacitor are configured to be connected in series., the third capacitor and the fourth capacitor are configured to be connected in series, wherein the series-connected first capacitor and the second capacitor are configured to be connected in parallel with the series-connected third capacitor and the fourth capacitor, wherein, in the third read-out operating mode, the method comprises:
biasing the first stator (134) with the first bias voltage source (404);
biasing the second stator (138) with the second bias voltage source (402);
coupling the first membrane (112) and the third membrane (116) to a predetermined voltage potential; and
reading-out an output signal through the first amplifier (422) connected to the second membrane (114);
d) in the fourth read-out operating mode, the first capacitor, the second capacitor, the third capacitor and the fourth capacitor are configured to be connected in series, the arrangement of the four capacitor forms a serial single ended read-out configuration, wherein the motor sensitivity provided to the first amplifier (422) is equal to four times the motor sensitivity of a single MEMS element, the output capacitance coupled to the first amplifier (422) is equal to one fourth of the output capacitance of a single MEMS element, wherein. in the fourth read-out operating mode, the method comprises:
biasing the first stator (134) and the second stator (138) with the second bias voltage source (402);
coupling the first membrane (112) and the second membrane (114) to a predetermined voltage potential; and
reading-out an output signal through the first amplifier (422) connected to the third membrane (116);
e) in the fifth read-out operating mode, the first bias voltage source (402) is configured to bias the first membrane (112) and a top electrode layer (115) of the second membrane (114), the second bias voltage source (404) is configured to bias the third membrane (116) and a bottom electrode layer (113) of the second membrane (114), wherein, in the fifth read-out operating mode, the method comprises:
biasing the first membrane (112) and a top electrode layer (115) of the second membrane (114) with the first bias voltage source (404);
biasing the third membrane (116) and a bottom electrode layer (113) of the second membrane (114) with the second bias voltage source (402); and
reading-out an output signal through the first amplifier (422) connected to the first stator (134) and the second stator (138), wherein
in the fifth read-out operating mode, the first capacitor, the second capacitor the third capacitor and the fourth capacitor are configured to be connected in parallel;
f) in the sixth read-out operating mode, the first capacitor and the third capacitor are configured to be connected in parallel and form a first read-out electrode, the second capacitor and the fourth capacitor are configured to be connected in parallel and form a second read-out electrode, wherein in the sixth read-out operating mode, the method comprises:
biasing the first stator (134) and the second stator (138) with the second bias voltage source (402);
reading-out a positive output signal through the first amplifier (422) connected to the third membrane (116) and a bottom electrode layer (113) of the second membrane (114); and
reading-out a negative output signal through the second amplifier (424) connected to the first membrane (112) and a top electrode layer (115) of the second membrane (114), wherein
in the sixth read-out operating mode, the first capacitor and the third capacitor are configured to be connected in parallel and form a first read-out electrode, and the second capacitor and the fourth capacitor are configured to be connected in parallel and form a second read-out electrode.

2. The method of claim 1, wherein, in the second read-out operating mode, the predetermined voltage potential is in a range from about 0.1 V to about 1 V.

3. A triple-membrane MEMS device (100) comprising:
a first membrane (112), a second membrane (114) and a third membrane (116) spaced apart from one another, wherein the second membrane (114) is between the first membrane (112) and the third membrane (116);
a first stator (134) between the first membrane (112) and the second membrane (114), and a second stator (138) between the second membrane (114) and the third membrane (116);
a sealed low pressure chamber between the first membrane (112) and the third membrane (116);
the first stator (134) and the second stator (138) in the sealed low pressure chamber; and
a signal processing circuit configured to read-out output signals of the triple-membrane MEMS device (100), wherein the signal processing circuit comprises a first bias voltage source (402), a first resistor (412), and a first amplifier (422), wherein the first capacitor, the second capacitor, the third capacitor and the fourth capacitor are configured in a series configuration to increase motor sensitivity of the MEMS device (100) or in a parallel configuration to reduce an output impedance of the MEMS device (100), when reading out the output signals in one of a first, a second, a third, a fourth, a fifth or a sixth read-out operations mode, wherein
a) in the first read-out operating mode, the first capacitor and the second capacitor are configured to be connected in parallel through the first bias voltage source (402) and a second bias voltage source (404), the third capacitor and the fourth capacitor are configured to be connected in parallel through the first bias voltage source (402) and the second bias voltage source (404), the first bias voltage source (404) is configured to bias the first membrane (112) and the third membrane (116), the negative bias voltage source (402) is configured to bias the second membrane (114), the first amplifier (422) is connected to the second stator (138) and is configured to read-out a positive output signal of the triple-membrane MEMS device (100), and the second amplifier (424) is connected to the first stator (134) and is configured to read-out a negative output signal of the triple-membrane MEMS device (100);
b) in the second read-out operating mode, the first capacitor and the second capacitor are configured to be connected in series., the third capacitor and the fourth capacitor are configured to be connected in series; the arrangement of the four capacitor forms a serial differential read-out configuration, wherein the motor sensitivity provided to the first amplifier (422) and the second amplifier (424) is equal to two times the motor sensitivity of a single MEMS element wherein the output capacitance coupled to the first amplifier (422) and the second amplifier (424) is equal to one half of the output capacitance of a single MEMS element, the second bias voltage source (402) is configured to bias the first stator (134) and the second stator (138), a predetermined voltage potential is configured to be coupled to the second membrane (114), the first amplifier (422) is connected to the third membrane (116) and is configured to read-out a positive output signal of the triple-membrane MEMS device (100), and the second amplifier (424) is connected to the first membrane (112) and is configured to read-out a negative output signal of the triple-membrane MEMS device (100);
c) in the third read-out operating mode, the first capacitor and the second capacitor are configured to be connected in series., the third capacitor and the fourth capacitor are configured to be connected in series, wherein the series-connected first capacitor and the second capacitor are configured to be connected in parallel with the series-connected third capacitor and the fourth capacitor, the first bias voltage source (404) is configured to bias the first stator (134), the second bias voltage source (402) is configured to bias the second stator (138), a predetermined voltage potential is configured to be coupled to the first membrane (112) and the third membrane (116), and the first amplifier (422) is connected to the second membrane (114) and is configured to read-out an output signal of the triple-membrane MEMS device (100);
d) in the fourth read-out operating mode, the first capacitor, the second capacitor, the third capacitor and the fourth capacitor are configured to be connected in series, the arrangement of the four capacitor forms a serial single ended read-out configuration, wherein the motor sensitivity provided to the first amplifier (422) is equal to four times the motor sensitivity of a single MEMS element, the output capacitance coupled to the first amplifier (422) is equal to one fourth of the output capacitance of a single MEMS element, the second bias voltage source (402) is configured to bias the first stator (134) and the second stator (138), a predetermined voltage potential is configured to be coupled to the first membrane (112) and the second membrane (114), and the first amplifier (422) is connected to the third membrane (116) and is configured to read-out an output signal of the triple-membrane MEMS device (100);
e) in the fifth read-out operating mode, the first bias voltage source (402) is configured to bias the first membrane (112) and a top electrode layer (115) of the second membrane (114), the second bias voltage source (404) is configured to bias the third membrane (116) and a bottom electrode layer (113) of the second membrane (114), the first bias voltage source (402) is configured to bias the first membrane (112) and a top electrode layer (115) of the second membrane (114), the second bias voltage source (404) is configured to bias the third membrane (116) and the bottom electrode layer (113) of the second membrane (114), the first amplifier (422) is connected to the first stator (134) and the second stator (138), and the first amplifier (422) is configured to read-out an output signal of the triple-membrane MEMS microphone;
f) in the sixth read-out operating mode, the first capacitor and the third capacitor are configured to be connected in parallel and form a first read-out electrode., the second capacitor and the fourth capacitor are configured to be connected in parallel and form a second read-out electrode, the third membrane (116) and a bottom electrode layer (113) of the second membrane (114) are connected together and further connected to an input of the first amplifier (422), the first amplifier (422) is configured to read-out a positive output signal of the triple-membrane MEMS microphone, the first membrane (112) and a top electrode layer (115) of the second membrane (114) are connected together and further connected to an input of the second amplifier (424), and the second amplifier (424) is configured to read-out a negative output signal of the triple-membrane MEMS microphone.

## Patentansprüche

1. Ein Verfahren zum Auslesen eines Mikroelektromechanisches-System(MEMS)-Bauelements (100), wobei das MEMS-Bauelement (100) eine erste Membran (112), eine zweite Membran (114) und eine dritte Membran (116), die voneinander beabstandet sind, wobei die zweite Membran (114) zwischen der ersten Membran (112) und der dritten Membran (116) liegt, einen ersten Stator (134) zwischen der ersten Membran (112) und der zweiten Membran (114) und einen zweiten Stator (138) zwischen der zweiten Membran (114) und der dritten Membran (116) und eine abgedichtete Niederdruckkammer zwischen der ersten Membran (112) und der dritten Membran (116) aufweist;
wobei der erste Stator (134) und der zweite Stator (138) in der abgedichteten Niederdruckkammer liegen; und
eine Signalverarbeitungsschaltung, die dazu konfiguriert ist, Ausgangssignale des Dreimembran-MEMS-Bauelements (100) auszulesen, wobei die Signalverarbeitungsschaltung eine erste Vorspannungsquelle (402), einen ersten Widerstand (412) und einen ersten Verstärker (422) aufweist, wobei das Verfahren folgende Schritte aufweist:
Bilden eines ersten Kondensators zwischen der ersten Membran (112) und dem ersten Stator (134), eines zweiten Kondensators zwischen dem ersten Stator (134) und der zweiten Membran (114), eines dritten Kondensators zwischen der zweiten Membran (114) und dem zweiten Stator (138) und eines vierten Kondensators zwischen dem zweiten Stator (138) und der dritten Membran (116); und
Konfigurieren des ersten Kondensators, des zweiten Kondensators, des dritten Kondensators und des vierten Kondensators in einer Reihenkonfiguration, um die Motorempfindlichkeit des MEMS-Bauelements (100) zu erhöhen, oder in einer Parallelkonfiguration, um eine Ausgangsimpedanz des MEMS-Bauelements (100) zu verringern, wenn die Ausgangssignale in einem aus einem ersten, einem zweiten, einem dritten, einem vierten, einem fünften oder einem sechsten Auslesebetriebsmodus ausgelesen werden, wobei
a) in dem ersten Auslesebetriebsmodus der erste Kondensator und der zweite Kondensator dazu konfiguriert sind, durch die erste Vorspannungsquelle (402) und eine zweite Vorspannungsquelle (404) parallel geschaltet zu werden, und der dritte Kondensator und der vierte Kondensator dazu konfiguriert sind, durch die erste Vorspannungsquelle (402) und die zweite Vorspannungsquelle (404) parallel geschaltet zu werden, wobei in dem ersten Auslesebetriebsmodus entsprechend einer der Parallelkonfigurationen das Verfahren folgende Schritte aufweist:
Vorspannen der ersten Membran (112) und der dritten Membran (116) mit der ersten Vorspannungsquelle (404);
Vorspannen der zweiten Membran (114) mit der zweiten Vorspannungsquelle (402);
Auslesen eines positiven Ausgangssignals durch den ersten Verstärker (422), der mit dem zweiten Stator (138) verbunden ist; und
Auslesen eines negativen Ausgangssignals durch den zweiten Verstärker (424), der mit dem ersten Stator (134) verbunden ist;
b) in dem zweiten Auslesebetriebsmodus der erste Kondensator und der zweite Kondensator dazu konfiguriert sind, in Reihe geschaltet zu werden, und der dritte Kondensator und der vierte Kondensator dazu konfiguriert sind, in Reihe geschaltet zu werden, wobei die Anordnung der vier Kondensatoren eine serielle differentielle Auslesekonfiguration bildet, wobei die Motorempfindlichkeit, die dem ersten Verstärker (422) und dem zweiten Verstärker (424) bereitgestellt wird, gleich dem Zweifachen der Motorempfindlichkeit eines einzelnen MEMS-Elements ist, wobei die Ausgangskapazität, die mit dem ersten Verstärker (422) und dem zweiten Verstärker (424) gekoppelt ist, gleich der Hälfte der Ausgangskapazität eines einzelnen MEMS-Elements ist, wobei in dem zweiten Auslesebetriebsmodus das Verfahren folgende Schritte aufweist:
Vorspannen des ersten Stators (134) und des zweiten Stators (138) mit der zweiten Vorspannungsquelle (402);
Koppeln der zweiten Membran (114) mit einem vorbestimmten Spannungspotential;
Auslesen eines positiven Ausgangssignals durch den ersten Verstärker (422), der mit der dritten Membran (116) verbunden ist; und
Auslesen eines negativen Ausgangssignals durch den zweiten Verstärker (424), der mit der ersten Membran (112) verbunden ist;
c) in dem dritten Auslesebetriebsmodus der erste Kondensator und der zweite Kondensator dazu konfiguriert sind, in Reihe geschaltet zu werden, und der dritte Kondensator und der vierte Kondensator dazu konfiguriert sind, in Reihe geschaltet zu werden, wobei der in Reihe geschaltete erste Kondensator und der zweite Kondensator dazu konfiguriert sind, mit dem in Reihe geschalteten dritten Kondensator und dem vierten Kondensator parallel geschaltet zu werden, wobei in dem dritten Auslesebetriebsmodus das Verfahren folgende Schritte aufweist:
Vorspannen des ersten Stators (134) mit der ersten Vorspannungsquelle (404);
Vorspannen des zweiten Stators (138) mit der zweiten Vorspannungsquelle (402);
Koppeln der ersten Membran (112) und der dritten Membran (116) mit einem vorbestimmten Spannungspotential; und
Auslesen eines Ausgangssignals durch den ersten Verstärker (422), der mit der zweiten Membran (114) verbunden ist;
d) in dem vierten Auslesebetriebsmodus der erste Kondensator, der zweite Kondensator, der dritte Kondensator und der vierte Kondensator dazu konfiguriert sind, in Reihe geschaltet zu werden, wobei die Anordnung der vier Kondensatoren eine serielle einpolige Auslesekonfiguration bildet, wobei die Motorempfindlichkeit, die dem ersten Verstärker (422) bereitgestellt wird, gleich dem Zweifachen der Motorempfindlichkeit eines einzelnen MEMS-Elements ist, und die Ausgangskapazität, die mit dem ersten Verstärker (422) gekoppelt ist, gleich einem Viertel der Ausgangskapazität eines einzelnen MEMS-Elements ist, wobei in dem vierten Auslesebetriebsmodus das Verfahren folgende Schritte aufweist:
Vorspannen des ersten Stators (134) und des zweiten Stators (138) mit der zweiten Vorspannungsquelle (402);
Koppeln der ersten Membran (112) und der zweiten Membran (114) mit einem vorbestimmten Spannungspotential; und
Auslesen eines Ausgangssignals durch den ersten Verstärker (422), der mit der dritten Membran (116) verbunden ist;
e) in dem fünften Auslesebetriebsmodus die erste Vorspannungsquelle (402) dazu konfiguriert ist, die erste Membran (112) und eine obere Elektrodenschicht (115) der zweiten Membran (114) vorzuspannen, und die zweite Vorspannungsquelle (404) dazu konfiguriert ist, die dritte Membran (116) und eine untere Elektrodenschicht (113) der zweiten Membran (114) vorzuspannen, wobei in dem fünften Auslesebetriebsmodus das Verfahren folgende Schritte aufweist:
Vorspannen der ersten Membran (112) und einer oberen Elektrodenschicht (115) der zweiten Membran (114) mit der ersten Vorspannungsquelle (404);
Vorspannen der dritten Membran (116) und einer unteren Elektrodenschicht (113) der zweiten Membran (114) mit der zweiten Vorspannungsquelle (402); und
Auslesen eines Ausgangssignals durch den ersten Verstärker (422), der mit dem ersten Stator (134) und dem zweiten Stator (138) verbunden ist, wobei in dem fünften Auslesebetriebsmodus der erste Kondensator, der zweite Kondensator, der dritte Kondensator und der vierte Kondensator dazu konfiguriert sind, parallel geschaltet zu werden;
f) in dem sechsten Auslesebetriebsmodus der erste Kondensator und der dritte Kondensator dazu konfiguriert sind, parallel geschaltet zu werden und eine erste Ausleseelektrode zu bilden, und der zweite Kondensator und der vierte Kondensator dazu konfiguriert sind, parallel geschaltet zu werden und eine zweite Ausleseelektrode zu bilden, wobei in dem sechsten Auslesebetriebsmodus das Verfahren folgende Schritte aufweist:
Vorspannen des ersten Stators (134) und des zweiten Stators (138) mit der zweiten Vorspannungsquelle (402);
Auslesen eines positiven Ausgangssignals durch den ersten Verstärker (422), der mit der dritten Membran (116) und einer unteren Elektrodenschicht (113) der zweiten Membran (114) verbunden ist; und
Auslesen eines negativen Ausgangssignals durch den zweiten Verstärker (424), der mit der ersten Membran (112) und einer oberen Elektrodenschicht (115) der zweiten Membran (114) verbunden ist, wobei
in dem sechsten Auslesebetriebsmodus der erste Kondensator und der dritte Kondensator dazu konfiguriert sind, parallel geschaltet zu werden und eine erste Ausleseelektrode zu bilden, und der zweite Kondensator und der vierte Kondensator dazu konfiguriert sind, parallel geschaltet zu werden und eine zweite Ausleseelektrode zu bilden.

2. Das Verfahren gemäß Anspruch 1, wobei in dem zweiten Auslesebetriebsmodus das vorbestimmte Spannungspotential in einem Bereich von etwa 0,1 V bis etwa 1 V liegt.

3. Ein Dreimembran-MEMS-Bauelement (100), das folgende Merkmale aufweist:
eine erste Membran (112), eine zweite Membran (114) und eine dritte Membran (116), die voneinander beabstandet sind, wobei die zweite Membran (114) zwischen der ersten Membran (112) und der dritten Membran (116) liegt;
einen ersten Stator (134) zwischen der ersten Membran (112) und der zweiten Membran (114) und einen zweiten Stator (138) zwischen der zweiten Membran (114) und der dritten Membran (116);
eine abgedichtete Niederdruckkammer zwischen der ersten Membran (112) und der dritten Membran (116);
den ersten Stator (134) und den zweiten Stator (138) in der abgedichteten Niederdruckkammer; und
eine Signalverarbeitungsschaltung, die dazu konfiguriert ist, Ausgangssignale des Dreimembran-MEMS-Bauelements (100) auszulesen, wobei die Signalverarbeitungsschaltung eine erste Vorspannungsquelle (402), einen ersten Widerstand (412) und einen ersten Verstärker (422) aufweist, wobei der erste Kondensator, der zweite Kondensator, der dritte Kondensator und der vierte Kondensator in einer Reihenkonfiguration, um die Motorempfindlichkeit des MEMS-Bauelements (100) zu erhöhen, oder in einer Parallelkonfiguration, um eine Ausgangsimpedanz des MEMS-Bauelements (100) zu verringern, konfiguriert sind, wenn die Ausgangssignale in einem aus einem ersten, einem zweiten, einem dritten, einem vierten, einem fünften oder einem sechsten Auslesebetriebsmodus ausgelesen werden, wobei
a) in dem ersten Auslesebetriebsmodus der erste Kondensator und der zweite Kondensator dazu konfiguriert sind, durch die erste Vorspannungsquelle (402) und eine zweite Vorspannungsquelle (404) parallel geschaltet zu werden, der dritte Kondensator und der vierte Kondensator dazu konfiguriert sind, durch die erste Vorspannungsquelle (402) und die zweite Vorspannungsquelle (404) parallel geschaltet zu werden, die erste Vorspannungsquelle (404) dazu konfiguriert ist, die erste Membran (112) und die dritte Membran (116) vorzuspannen, die negative Vorspannungsquelle (402) dazu konfiguriert ist, die zweite Membran (114) vorzuspannen, der erste Verstärker (422) mit dem zweiten Stator (138) verbunden ist und dazu konfiguriert ist, ein positives Ausgangssignal des Dreimembran-MEMS-Bauelements (100) auszulesen, und der zweite Verstärker (424) mit dem ersten Stator (134) verbunden ist und dazu konfiguriert ist, ein negatives Ausgangssignal des Dreimembran-MEMS-Bauelements (100) auszulesen;
b) in dem zweiten Auslesebetriebsmodus der erste Kondensator und der zweite Kondensator dazu konfiguriert sind, in Reihe geschaltet zu werden, und der dritte Kondensator und der vierte Kondensator dazu konfiguriert sind, in Reihe geschaltet zu werden, wobei die Anordnung der vier Kondensatoren eine serielle differentielle Auslesekonfiguration bildet, wobei die Motorempfindlichkeit, die dem ersten Verstärker (422) und dem zweiten Verstärker (424) bereitgestellt wird, gleich dem Zweifachen der Motorempfindlichkeit eines einzelnen MEMS-Elements ist, wobei die Ausgangskapazität, die mit dem ersten Verstärker (422) und dem zweiten Verstärker (424) gekoppelt ist, gleich der Hälfte der Ausgangskapazität eines einzelnen MEMS-Elements ist, die zweite Vorspannungsquelle (402) dazu konfiguriert ist, den ersten Stator (134) und den zweiten Stator (138) vorzuspannen, ein vorbestimmtes Spannungspotential dazu konfiguriert ist, mit der zweiten Membran (114) gekoppelt zu werden, der erste Verstärker (422) mit der dritten Membran (116) verbunden ist und dazu konfiguriert ist, ein positives Ausgangssignal des Dreimembran-MEMS-Bauelements (100) auszulesen, und der zweite Verstärker (424) mit der ersten Membran (112) verbunden ist und dazu konfiguriert ist, ein negatives Ausgangssignal des Dreimembran-MEMS-Bauelements (100) auszulesen;
c) in dem dritten Auslesebetriebsmodus der erste Kondensator und der zweite Kondensator dazu konfiguriert sind, in Reihe geschaltet zu werden, und der dritte Kondensator und der vierte Kondensator dazu konfiguriert sind, in Reihe geschaltet zu werden, wobei der in Reihe geschaltete erste Kondensator und der zweite Kondensator dazu konfiguriert sind, mit dem in Reihe geschalteten dritten Kondensator und dem vierten Kondensator parallel geschaltet zu werden, die erste Vorspannungsquelle (404) dazu konfiguriert ist, den ersten Stator (134) vorzuspannen, die zweite Vorspannungsquelle (402) dazu konfiguriert ist, den zweiten Stator (138) vorzuspannen, ein vorbestimmtes Spannungspotential dazu konfiguriert ist, mit der ersten Membran (112) und der dritten Membran (116) gekoppelt zu werden, und der erste Verstärker (422) mit der zweiten Membran (114) verbunden ist und dazu konfiguriert ist, ein Ausgangssignal des Dreimembran-MEMS-Bauelements (100) auszulesen;
d) in dem vierten Auslesebetriebsmodus der erste Kondensator, der zweite Kondensator, der dritte Kondensator und der vierte Kondensator dazu konfiguriert sind, in Reihe geschaltet zu werden, wobei die Anordnung der vier Kondensatoren eine serielle einpolige Auslesekonfiguration bildet, wobei die Motorempfindlichkeit, die dem ersten Verstärker (422) bereitgestellt wird, gleich dem Zweifachen der Motorempfindlichkeit eines einzelnen MEMS-Elements ist, die Ausgangskapazität, die mit dem ersten Verstärker (422) gekoppelt ist, gleich einem Viertel der Ausgangskapazität eines einzelnen MEMS-Elements ist, die zweite Vorspannungsquelle (402) dazu konfiguriert ist, den ersten Stator (134) und den zweiten Stator (138) vorzuspannen, ein vorbestimmtes Spannungspotential dazu konfiguriert ist, mit der ersten Membran (112) und der zweiten Membran (114) gekoppelt zu werden, und der erste Verstärker (422) mit der dritten Membran (116) verbunden ist und dazu konfiguriert ist, ein Ausgangssignal des Dreimembran-MEMS-Bauelements (100) auszulesen;
e) in dem fünften Auslesebetriebsmodus die erste Vorspannungsquelle (402) dazu konfiguriert ist, die erste Membran (112) und eine obere Elektrodenschicht (115) der zweiten Membran (114) vorzuspannen, die zweite Vorspannungsquelle (404) dazu konfiguriert ist, die dritte Membran (116) und eine untere Elektrodenschicht (113) der zweiten Membran (114) vorzuspannen, die erste Vorspannungsquelle (402) dazu konfiguriert ist, die erste Membran (112) und eine obere Elektrodenschicht (115) der zweiten Membran (114) vorzuspannen, die zweite Vorspannungsquelle (404) dazu konfiguriert ist, die dritte Membran (116) und die untere Elektrodenschicht (113) der zweiten Membran (114) vorzuspannen, der erste Verstärker (422) mit dem ersten Stator (134) und dem zweiten Stator (138) verbunden ist und der erste Verstärker (422) dazu konfiguriert ist, ein Ausgangssignal des Dreimembran-MEMS-Mikrofons auszulesen;
f) in dem sechsten Auslesebetriebsmodus der erste Kondensator und der dritte Kondensator dazu konfiguriert sind, parallel geschaltet zu werden und eine erste Ausleseelektrode zu bilden, der zweite Kondensator und der vierte Kondensator dazu konfiguriert sind, parallel geschaltet zu werden und eine zweite Ausleseelektrode zu bilden, die dritte Membran (116) und eine untere Elektrodenschicht (113) der zweiten Membran (114) miteinander verbunden sind und ferner mit einem Eingang des ersten Verstärkers (422) verbunden sind, der erste Verstärker (422) dazu konfiguriert ist, ein positives Ausgangssignal des Dreimembran-MEMS-Mikrofons auszulesen, die erste Membran (112) und eine obere Elektrodenschicht (115) der zweiten Membran (114) miteinander verbunden sind und ferner mit einem Eingang des zweiten Verstärkers (424) verbunden sind, und der zweite Verstärker (424) dazu konfiguriert ist, ein negatives Ausgangssignal des Dreimembran-MEMS-Mikrofons auszulesen.

## Revendications

1. Un procédé de lecture d'un dispositif (100) à système microélectromécanique (MEMS), le dispositif (100) à MEMS comprenant une première membrane (112), une deuxième membrane (114) et une troisième membrane (116) à distance les unes des autres, la deuxième membrane (114) étant entre la première membrane (112) et la troisième membrane (116), un premier stator (134) entre la première membrane (112) et la deuxième membrane (114) et un deuxième stator (138) entre la deuxième membrane (114) et la troisième membrane (116), une chambre étanche sous basse pression entre la première membrane (112) et la troisième membrane (116) ;
le premier stator (134) et le deuxième stator (138) étant dans la chambre étanche sous basse pression ; et
une unité de traitement du signal configurée pour lire des signaux de sortie du dispositif (100) à MEMS à triple membrane, dans lequel l'unité de traitement du signal comprend une première source (402) de tension polarisée, une première résistance (412) et un premier amplificateur (422), le procédé comprenant :
former un premier condensateur entre la première membrane (112) et le premier stator (134), un deuxième condensateur entre le première stator (134) et la deuxième membrane (114), un troisième condensateur entre la deuxième membrane (114) et le deuxième stator (138) et un quatrième condensateur entre le deuxième stator (138) et la troisième membrane (116) ; et
configurer le premier condensateur, le deuxième condensateur, le troisième condensateur et le quatrième condensateur suivant un montage en série pour augmenter la sensibilité motrice du dispositif (100) à MEMS ou suivant un montage en parallèle pour réduire une impédance de sortie du dispositif (100) à MEMS lors de la lecture des signaux de sortie dans l'un d'un premier, d'un deuxième, d'un troisième, d'un quatrième, d'un cinquième ou d'un sixième mode de fonctionnement en lecture, dans lequel,
a) dans le premier mode de fonctionnement en lecture, le premier condensateur et le deuxième condensateur sont configurés pour être montés en parallèle par la première source (402) de tension polarisée et par une deuxième source (404) de tension polarisée, le troisième condensateur et le quatrième condensateur sont configurés pour être montés en parallèle par la première source (402) de tension polarisée et la deuxième source (404) de tension polarisée, dans lequel, dans le premier mode de fonctionnement en lecture correspondant à l'un des montages en parallèle, le procédé comprend :
polariser la première membrane (112) et la troisième membrane (116) par la première source (404) de tension polarisée ;
polariser la deuxième membrane (114) par le deuxième source (402) de tension polarisée ;
lire un signal positif de sortie par le premier amplificateur (422) connecté au deuxième stator (138) ; et
lire un signal négatif de sortie par le deuxième amplificateur (424) connecté au premier stator (134) ;
b) dans le deuxième mode de fonctionnement en lecture, le premier condensateur et le deuxième condensateur sont configurés pour être montés en série, le troisième condensateur et le quatrième condensateur sont configurés pour être montés en série ; l'agencement des quatre condensateurs forme une configuration de lecture différentielle série, dans lequel la sensibilité motrice donnée au premier amplificateur (422) et au deuxième amplificateur (424) est égale à deux fois la sensibilité motrice d'un élément individuel de MEMS, dans lequel la capacité de sortie donnée au premier amplificateur (422) et au deuxième amplificateur (424) est égale à une moitié de la capacité de sortie d'un élément individuel de MEMS, dans lequel, dans le deuxième mode de fonctionnement en lecture, le procédé comprend :
polariser le premier stator (134) et le deuxième stator (138) par la deuxième source (402) de tension polarisée ;
appliquer un potentiel de tension déterminé à l'avance à la deuxième membrane (114) ;
lire un signal positif de sortie par le premier amplificateur (422) connecté à la troisième membrane (116) ; et
lire un signal négatif de sortie par le deuxième amplificateur (424) connecté à la première membrane (112);
c) dans le troisième mode de fonctionnement en lecture, le premier condensateur et le deuxième condensateur sont configurés pour être montés en série, le troisième condensateur et le quatrième condensateur sont configurés pour être montés en série, dans lequel le premier condensateur et le deuxième condensateur montés en série sont configurés pour être montés en parallèle avec le troisième condensateur et le quatrième condensateur montés en série, dans lequel, dans le troisième mode de fonctionnement en lecture, le procédé comprend :
polariser le premier stator (134) par la première source (404) de tension polarisée ;
polariser le deuxième stator (138) par la deuxième source (402) de tension polarisée ;
appliquer un potentiel de tension déterminé à l'avance à la première membrane (112) et à la troisième membrane (116) ; et
lire un signal de sortie par le premier amplificateur (422) connecté à la deuxième membrane (114) ;
d) dans le quatrième mode de fonctionnement en lecture, le premier condensateur, le deuxième condensateur, le troisième condensateur et le quatrième condensateur sont configurés pour être montés en série, l'agencement des quatre condensateurs forme une configuration de lecture série asymétrique, dans lequel la sensibilité motrice donnée au premier amplificateur (422) est égale à quatre fois la sensibilité motrice d'un élément individuel de MEMS, la capacité de sortie couplée au premier amplificateur (422) est égale à un quart de la capacité de sortie d'un élément individuel de MEMS, dans lequel, dans le quatrième mode de fonctionnement en lecture, le procédé comprend :
polariser le premier stator (134) et le deuxième stator (138) par la deuxième source (402) de tension polarisée ;
appliquer un potentiel de tension déterminé à l'avance à la première membrane (112) et à la deuxième membrane (114) ; et
lire un signal de sortie par le premier amplificateur (422) connecté à la troisième membrane (116) ;
e) dans le cinquième mode de fonctionnement en lecture, la première source (402) de tension polarisée est configurée pour polariser la première membrane (112) et une couche (115) d'électrode de sommet de la deuxième membrane (114), la deuxième source (404) de tension polarisée est configurée pour polariser la troisième membrane (116) et une couche (113) d'électrode de fond de la deuxième membrane (114), dans lequel, dans le cinquième mode de fonctionnement en lecture, le procédé comprend :
polariser la première membrane (112) et une couche (115) d'électrode de sommet de la deuxième membrane (114) par la première source (404) de tension polarisée ;
polariser la troisième membrane (116) et une couche (113) d'électrode de fond de la deuxième membrane (114) par la deuxième source (402) de tension polarisée ; et
lire un signal de sortie par le premier amplificateur (422) connecté au premier stator (134) et au deuxième stator (138), dans lequel,
dans le cinquième mode de fonctionnement en lecture, le premier condensateur, le deuxième condensateur, le troisième condensateur et le quatrième condensateur sont configurés pour être montés en parallèle ;
f) dans le sixième mode de fonctionnement en lecture, le premier condensateur et le troisième condensateur sont configurés pour être montés en parallèle et forment une première électrode de lecture, le deuxième condensateur et le quatrième condensateur sont configurés pour être montés en parallèle et forment une deuxième électrode de lecture, dans lequel, dans le sixième mode de fonctionnement en lecture, le procédé comprend :
polariser le premier stator (134) et le deuxième stator (138) par la deuxième source (402) de tension de polarisation ;
lire un signal positif de sortie par le premier amplificateur (422) connecté à la troisième membrane (116) et à une couche (113) d'électrode de fond de la deuxième membrane (114) ; et
lire un signal négatif de sortie par le deuxième amplificateur (424) connecté à la première membrane (112) et à une couche (115) d'électrode de sommet de la deuxième membrane (114), dans lequel,
dans le sixième mode de fonctionnement en lecture, le premier condensateur et le troisième condensateur sont configurés pour être montés en parallèle et forment une première électrode de sortie et le deuxième condensateur et le quatrième condensateur sont configurés pour être montés en parallèle et forment une deuxième électrode de sortie.

2. Le procédé de la revendication 1, dans lequel, dans le deuxième mode de fonctionnement en lecture, le potentiel de tension déterminé à l'avance est dans une plage de 0,1 V à environ 1 V.

3. Un dispositif (100) à MEMS à triple membrane comprenant :
une première membrane (112), une deuxième membrane (114) et une troisième membrane (116) à distance les unes des autres, dans lequel la deuxième membrane (114) est entre la première membrane (112) et la troisième membrane (116) ;
un premier stator (134) entre la première membrane (112) et la deuxième membrane (114) et un deuxième stator (138) entre la deuxième membrane (114) et la troisième membrane (116) ;
une chambre étanche sous basse pression entre la première membrane (112) et la troisième membrane (116) ;
le premier stator (134) et le deuxième stator (138) dans la chambre étanche sous basse pression ; et
une unité de traitement du signal configurée pour lire des signaux de sortie du dispositif (100) à MEMS à triple membrane, dans lequel l'unité de traitement du signal comprend une première source (402) de tension polarisée, une première résistance (412) et un premier amplificateur (422), dans lequel le premier condensateur, le deuxième condensateur, le troisième condensateur et le quatrième condensateur sont configurés en un montage en série pour augmenter la sensibilité motrice du dispositif (100) à MEMS ou suivant un montage en parallèle pour réduire une impédance de sortie du dispositif (100) à MEMS, lors de la lecture des signaux de sortie dans l'un d'un premier, d'un deuxième, d'un troisième, d'un quatrième, d'un cinquième ou d'un sixième mode de fonctionnement en lecture, dans lequel,
a) dans le premier mode de fonctionnement en lecture, le premier condensateur et le deuxième condensateur sont configurés pour être montés en parallèle par la première source (402) de tension polarisée et une deuxième source (404) de tension polarisée, le troisième condensateur et le quatrième condensateur sont configurés pour être montés en parallèle par la première source (402) de tension polarisée et la deuxième source (404) de tension polarisée, la première source (404) de tension polarisée est configurée pour polariser la première membrane (112) et la troisième membrane (116), la source (402) de tension polarisée négative est configurée pour polariser la deuxième membrane (114), le premier amplificateur (422) est connecté au deuxième stator (138) et est configuré pour lire un signal positif de sortie du dispositif (100) à MEMS à triple membrane, et le deuxième amplificateur (424) est connecté au premier stator (134) et est configuré pour lire un signal négatif de sortie du dispositif (100) à MEMS à triple membrane ;
b) dans le deuxième mode de fonctionnement en lecture, le premier condensateur et le deuxième condensateur sont configurés pour être montés en série, le troisième condensateur et le quatrième condensateur sont configurés pour être montés en série ; l'agencement des quatre condensateurs forme un montage de lecture différentiel série, dans lequel la sensibilité motrice donnée au premier amplificateur (422) et au deuxième amplificateur (424) est égale à deux fois la sensibilité motrice d'un élément individuel de MEMS, dans lequel la capacité de sortie couplée au premier amplificateur (422) et au deuxième amplificateur (424) est égale à une moitié de la capacité de sortie d'un élément individuel de MEMS, la deuxième source (402) de tension polarisée est configurée pour polariser le premier stator (134) et le deuxième stator (138), un potentiel de tension déterminé à l'avance est configuré pour être appliqué à la deuxième membrane (114), le premier amplificateur (422) est connecté à la troisième membrane (116) et est configuré pour dire un signal positif de sortie du dispositif (100) à MEMS à triple membrane, et le deuxième amplificateur (424) est connecté à la première membrane (112) et est configuré pour lire un signal négatif de sortie du dispositif (100) à MEMS à triple membrane ;
c) dans le troisième mode de fonctionnement en lecture, le premier condensateur et le deuxième condensateur sont configurés pour être montés en série, le troisième condensateur et le quatrième condensateur sont configurés pour être montés en série, dans lequel le premier condensateur et le deuxième condensateur montés en série sont configurés pour être montés en parallèle avec le troisième condensateur et le quatrième condensateur montés en série, la première source (404) de tension polarisée est configurée pour polariser le premier stator (134), la deuxième source (402) de tension polarisée est configurée pour polariser le deuxième stator (138), un potentiel de tension déterminé à l'avance est configuré pour être appliqué à la première membrane (112) et à la troisième membrane (116), et le premier amplificateur (422) est connecté à la deuxième membrane (114) et est configuré pour lire un signal de sortie du dispositif (100) à MEMS à triple membrane ;
d) dans le quatrième mode de fonctionnement en lecture, le premier condensateur, le deuxième condensateur, le troisième condensateur et le quatrième condensateur sont configurés pour être montés en série, l'agencement des quatre condensateurs forme un montage de lecture série asymétrique, dans lequel la sensibilité motrice donnée au premier amplificateur (422) est égale à quatre fois la sensibilité motrice d'un élément individuel de MEMS, la capacité de sortie couplée au premier amplificateur (422) est égale à un quart de la capacité de sortie d'un élément individuel de MEMS, la deuxième source (402) de tension polarisée est configurée pour polariser le premier stator (134) et le deuxième stator (138), un potentiel de tension déterminé à l'avance est configuré pour être appliqué à la première membrane (112) et à la deuxième membrane (114), et le premier amplificateur (422) est connecté à la troisième membrane (116) et est configuré pour lire un signal de sortie du dispositif (100) à MEMS à triple membrane ;
e) dans le cinquième mode de fonctionnement en lecture, la première source (402) de tension polarisée est configurée pour polariser la première membrane (112) et une couche (115) d'électrode de la deuxième membrane (114), la deuxième source (404) de tension polarisée est configurée pour polariser la troisième membrane (116) et une couche (113) d'électrode de fond de la deuxième membrane (114), la première source (402) de tension polarisée est configurée pour polariser la première membrane (112) et une couche (115) d'électrode de sommet de la deuxième membrane (114), la deuxième source (404) de tension polarisée est configurée pour polariser la troisième membrane (116) et la couche (113) d'électrode de fond de la deuxième membrane (114), le premier amplificateur (422) est connecté au premier stator (134) et au deuxième stator (138), et le premier amplificateur (422) est configuré pour lire un signal de sortie du microphone à MEMS à triple membrane ;
f) dans le sixième mode de fonctionnement en lecture, le premier condensateur et le troisième condensateur sont configurés pour être montés en parallèle et forment une première électrode de lecture, le deuxième condensateur et le quatrième condensateur sont configurés pour être montés en parallèle et forment une deuxième électrode de lecture, la troisième membrane (116) et une couche (113) d'électrode de fond de la deuxième membrane (114) sont connectées ensemble et connectées en outre à une entrée du premier amplificateur (422), le premier amplificateur (422) est configuré pour lire un signal positif de sortie, le microphone à MEMS à triple membrane, la première membrane (112) et une couche (115) d'électrode de sommet de la deuxième membrane (114) sont connectées ensemble et connectées en outre à une entrée du deuxième amplificateur (424) et le deuxième amplificateur (424) est configuré pour lire un signal négatif de sortie du microphone à MEMS à triple membrane.
